# FASCICULE DE BREVET EUROPEEN

(11) **EP 0 872 891 B1**
(45) Date de publication et mention de la délivrance du brevet: **21.07.2004**
(21) Numéro de dépôt: 98410041.2
(22) Date de dépôt: 15.04.1998
(51) Int. Cl.: H01L 27/02

(54) **Composant de protection d'interface de lignes téléphoniques**
Bauteil zum Schnittstellenschutz von Telefonleitungen
Device for protecting the interface of telephone lines

(30) Priorité: 17.04.1997 FR 9704982
(43) Date de publication de la demande: 21.10.1998
(73) Titulaire: STMicroelectronics S.A., 92120 Montrouge (FR)
(72) Inventeur: Bernier, Eric, 37390 Mettray (FR)
(74) Mandataire: de Beaumont, Michel

(56) Documents cités:
- EP-A- 0 687 051

## Description

La présente invention concerne un composant de protection, plus particulièrement applicable à la protection de lignes téléphoniques.

La demande de brevet européen EP-A-0687051 (B2420) de la demanderesse décrit un circuit de protection d'interface de lignes téléphoniques et des modes de réalisation particuliers de ce circuit sous forme de composant monolithique.

La figure 1 de la présente demande reproduit la figure 4 de cette demande de brevet antérieure et représente un élément de circuit comprenant deux thyristors tête-bêche Th1 et Th2, respectivement à gâchette de cathode et à gâchette d'anode, connectés entre une ligne AB et une borne de référence G. Les gâchettes sont reliées ensemble au point B. Une borne commune des thyristors est reliée au point A, une résistance Rd étant insérée entre les points A et B. L'autre borne commune des thyristors est reliée à la borne de référence G. Une diode Zener Z1 connectée entre les bornes B et G entraîne, quand elle entre en avalanche, le déclenchement du thyristor Th1 et une diode Zener Z2 connectée entre les bornes A et G entraîne, quand elle entre en avalanche, le déclenchement du thyristor Th2. Quand le courant entre les bornes A et B dépasse un seuil déterminé, l'un ou l'autre des thyristors Th1 et Th2 est mis en conduction par sa gâchette.

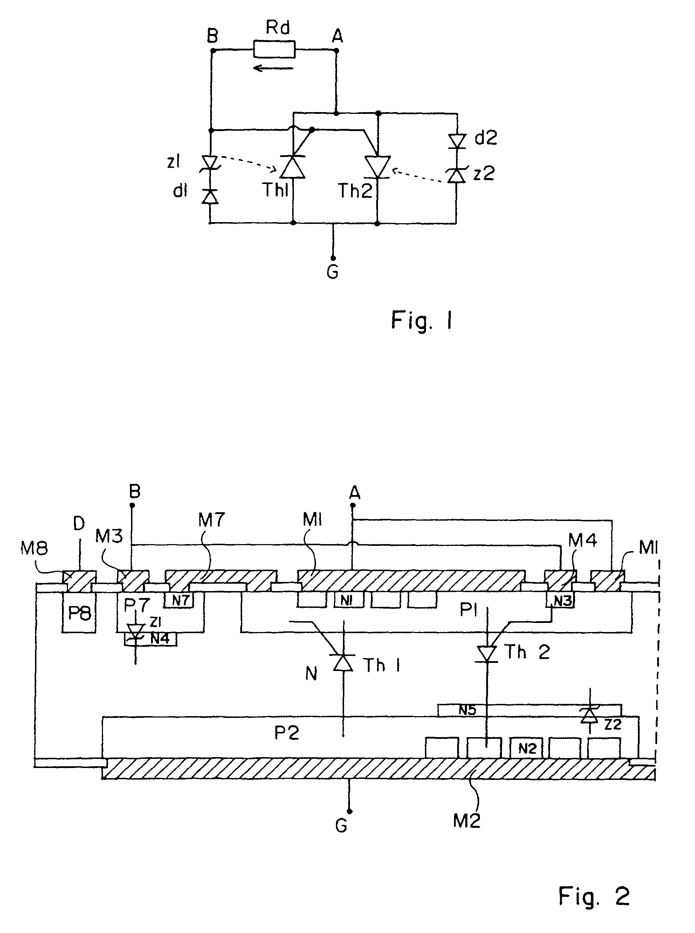

Ainsi, dans le circuit de la figure 1, selon la polarité en cause, l'un ou l'autre des thyristors Th1 et Th2 entre en conduction si le courant dans la résistance Rd dépasse un seuil déterminé ou si la tension sur la ligne AB dépasse la tension d'avalanche de la diode Z1 ou Z2.

La figure 2 de la présente demande reproduit la figure 7 de la demande de brevet susmentionnée et constitue un mode de réalisation du circuit de la figure 1. On a rajouté sur la figure 2 l'indication des emplacements des éléments Th1, Th2, Z1 et Z2 de la figure 1.

Toutefois, lors de la réalisation pratique du circuit, la demanderesse s'est aperçu que, si le déclenchement du thyristor Th1 à la suite de la mise en avalanche de la diode Zener Z1 ne posait pas de problèmes particuliers, la sensibilité de déclenchement du thyristor Th2 à la suite du passage d'un courant dans la résistance Rd devait encore être améliorée. Plus particulièrement, ce déclenchement s'est avéré trop lent (durée supérieure à 1 µs). Les efforts pour optimiser la topologie du composant (voir figures 8A et 8B de la demande de brevet européen EP-A-0687051) se sont avérés infructueux. Ainsi, quand une surintensité à front particulièrement raide (par exemple une onde normalisée 0,5/700 µs d'une intensité de 30 A) survient sur la ligne AB, le thyristor Th2 entre bien en conduction mais avec un certain retard et, pendant ce retard, le composant de protection va laisser passer l'intensité de crête de 30 A, ce qui peut dégrader le circuit intégré à protéger.

Pour résoudre ce problème et améliorer la vitesse de réaction du composant à la suite de l'apparition d'une surintensité positive sur la ligne AB, la demanderesse a proposé dans la demande de brevet européen 97/410008.3 (B3042) correspondant à la publication EP 785577 une modification de la structure du composant de la figure 2 et plus particulièrement de la partie de ce composant correspondant au thyristor Th2, comme cela est représenté en figure 3. Ce document constitué l'état de la technique sous article 54(3) CBE et n'est pas pris en considération pour l'appréciation de l'activité inventive.

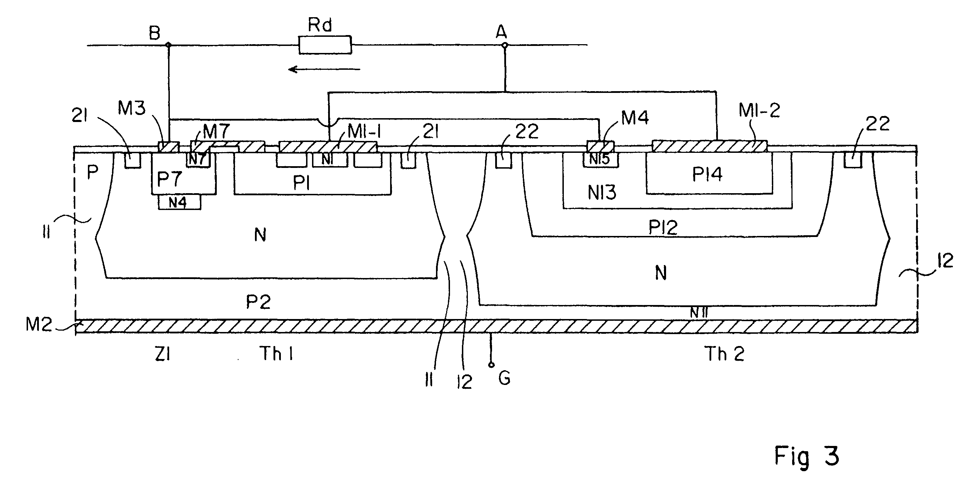

La figure 3 représente de façon schématique et simplifiée un exemple de réalisation monolithique du circuit de la figure 1. Ce composant est réalisé comme celui de la figure 2 à partir d'un substrat de type N. On retrouve dans la partie gauche du composant les mêmes éléments que ceux représentés dans la partie gauche de la figure 2 désignés par les mêmes références.

Une différence par rapport au circuit de la figure 2 est que cet ensemble de couches et de régions semiconductrices est formé dans un caisson isolé par des murs d'isolement 11 de type P pour isoler le thyristor Th1 et ses composants associés du thyristor Th2. Ces murs sont de façon classique formés par diffusion à partir des faces supérieure et inférieure du substrat. En outre, on n'a pas représenté en figure 3 la région P8 de détection de court-circuit mais celle-ci pourra bien entendu être prévue si on le souhaite.

La partie gauche de la figure 3 comprend, du côté de la face inférieure, du substrat, une couche P2 de type P et, du côté de la face supérieure du substrat, des régions P1 et P7 de type P dans lesquelles sont respectivement formées des régions N1 et N7 de type N. A l'interface entre la région P7 et le substrat N est formée une région N4 de type N.

La face inférieure de la plaquette est revêtue d'une métallisation M2. La région P7 est revêtue d'une métallisation M3. La région N7 et une portion de la région P1 sont revêtues d'une métallisation M7. La région N1 est revêtue d'une métallisation M1-1 qui correspond à une portion de la métallisation M1 de la figure 2.

Cette structure constitue une réalisation de l'ensemble du thyristor Th1 et de la diode Zener Z1 de la figure 1. Le thyristor Th1 comprend les régions N1-P1-N-P2 et est associé aux régions N7 et P7 pour constituer un thyristor à amplification de gâchette. La diode Zener Z1 est formée par la jonction entre les régions P7 et N4 spécialement conçue pour assurer cette fonction.

La partie droite de la figure 3 représente une réalisation des éléments correspondant à l'ensemble du thyristor Th2 et de la diode Zener Z2 de la figure 1. La diode Z2 correspond à l'une des jonctions du thyristor qui est un thyristor à déclenchement en direct par retournement. Cette structure est éventuellement formée dans un caisson isolé par des murs d'isolement 12 de type P.

Dans cette partie droite, la face arrière est occupée par une couche N11 de type N fortement dopée formée par diffusion ou implantation-diffusion. Du côté de la face avant, sont successivement formées une diffusion profonde P12 de type P ; à l'intérieur de la région P12, une diffusion profonde N13 de type N ; et à l'intérieur de la région N13, des régions disjointes P14 de type P et N15 de type N.

Le thyristor Th2, de son anode vers sa cathode, correspond à l'ensemble des régions et couches P14-N13-P12-N-N11. La région N15 est une région de reprise de contact de gâchette d'anode. La région d'anode P14 est revêtue d'une métallisation M1-2 reliée à la métallisation M1-1. La région N15 de reprise de contact de gâchette d'anode est revêtue d'une métallisation M4 correspondant à la métallisation portant la même référence en figure 2 et reliée à la borne B.

Dans cette structure, quand le thyristor Th2 est polarisé en direct, la jonction susceptible d'entrer en avalanche est la jonction N13-P12. C'est donc cette jonction qui doit être optimisée pour présenter un seuil de déclenchement désiré, de préférence voisin de celui de la jonction P7-N4. Les régions P12 et M13 étant formées par des diffusions successives, il est possible d'optimiser les niveaux de dopage et les profils de diffusion pour que cette jonction présente les caractéristiques souhaitées.

Egalement, si l'on considère le thyristor Th2 comme constitué d'un assemblage de deux transistors PNP P14-N13-P12 et NPN N13-P12-N-N11, les gains de ces transistors pourront être optimisés pour augmenter la sensibilité du thyristor Th2.

La réalisation d'un tel composant ne nécessite pas d'étape supplémentaire de fabrication par rapport à celles du composant de la figure 2 (en notant que, bien que l'on n'ait pas illustré dans la vue partielle de la figure 2 de mur d'isolement, il existera en pratique des murs d'isolement dans la structure d'ensemble dont le composant de la figure 2 fait partie). Plus particulièrement, la région P12 pourra être réalisée en même temps que la partie supérieure des murs d'isolement 11 et 12, la région N13 pourra être réalisée en même temps que la région N4, la région P14 en même temps que les régions P1 et P7 et la région N15 en même temps que les régions N1, N7 et N11. Toutefois, bien que résultant des mêmes étapes de diffusion, c'est-à-dire même durée et même température de recuit, ces diffusions pourront faire suite à des implantations de doses distinctes. En particulier, le niveau de dopage de la région P12 sera nettement inférieur à celui des murs d'isolement.

A titre d'exemple de valeurs numériques, on pourra choisir pour diverses régions les valeurs de concentration superficielle Cs (en at./cm³) et de profondeur de jonction xj (en µm) suivantes :

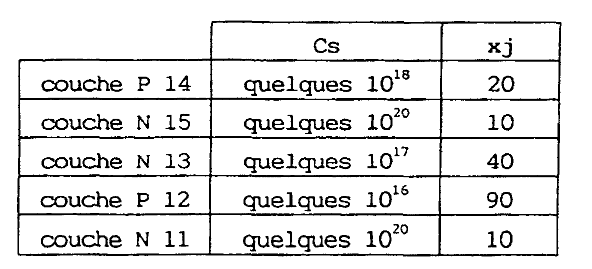

Avec le composant de la figure 3, on obtient une mise en conduction extrêmement rapide du thyristor Th2 à la suite d'une surintensité (moins de 1 µs après le début de la surintensité).

Ainsi, le composant de la figure 3 résout de façon satisfaisante la plupart des problèmes posés.

Toutefois, lors de la mise en oeuvre de ce composant, la demanderesse s'est aperçu que dans certaines configurations de signaux de sonnerie, le composant se déclenchait de façon indésirée. C'est ce que la présente invention vise à éviter.

La présente invention se base sur une analyse de ce problème. Comme cela sera exposé en détail ci-après, la demanderesse a constaté que le problème se posait notamment quand l'impédance à laquelle est appliqué le signal de sonnerie est faible et donc que l'intensité du signal de sonnerie est relativement importante tandis que l'on est en phase négative.

Pour résoudre ce problème, la présente invention prévoit un composant monolithique de protection contre des surcharges électriques susceptibles de se produire sur un conducteur en série avec lequel est disposée une résistance de détection, ce composant étant formé dans un substrat d'un premier type de conductivité ayant une face supérieure et une face inférieure et comprenant des premières et deuxièmes métallisations de face supérieure destinées à être connectées aux bornes de ladite résistance et une troisième métallisation de face inférieure destinée à être connectée à un potentiel de référence ; un premier thyristor vertical à gâchette de cathode isolé latéralement par un mur d'isolement du deuxième type de conductivité ; et un second thyristor vertical à gâchette d'anode, du type à déclenchement par courant de gâchette ou par retournement en direct, les premier et second thyristors étant formés tête-bêche entre les premières et troisième métallisations, les deuxièmes métallisations correspondant aux gâchettes de ces thyristors. La région d'anode du premier thyristor, formée du côté de la face inférieure, est disjointe dudit mur d'isolement et la face arrière du mur d'isolement est revêtue d'une portion de couche isolante.

Selon un mode de réalisation de la présente invention, le composant comprend une diode à avalanche entre les deuxième et troisième métallisations disposée pour que sa mise en avalanche provoque la mise en conduction en direct du premier thyristor, la tension de retournement du second thyristor étant sensiblement égale à la tension d'avalanche de ladite diode à avalanche.

Selon un mode de réalisation de la présente invention, l'ensemble du premier thyristor et de la diode à avalanche comprend une première couche du deuxième type de conductivité formée dans la surface inférieure du substrat et disjointe du mur d'isolement ; des deuxième et troisième régions du deuxième type de conductivité formées dans la surface supérieure du substrat ; des quatrième et cinquième régions du premier type de conductivité respectivement formées dans les deuxième et troisième régions ; et une sixième région du premier type de conductivité formée à l'interface entre la troisième région et le substrat.

Un avantage particulier de la présente invention est qu'elle permet au prix de modifications très minimes d'un composant préexistant (modification du masque d'une région de type P et du masque de couches isolantes de face arrière) de résoudre un problème qui rendait ce composant antérieur inutilisable dans certaines conditions de fonctionnement.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 correspond à la figure 4 de la demande de brevet européen EP-A-0687051 ;
la figure 2 correspond à la figure 7 de la demande de brevet européen EP-A-0687051 ;
la figure 3 correspond à la figure 3 de la demande de brevet européen EP-A-0687051 ;
les figures 4A à 4B représentent un schéma équivalent du composant de la figure 3 et illustrent le passage du courant dans diverses phases de fonctionnement ; et
la figure 5 représente un mode de réalisation du composant selon la présente invention.

Comme cela est usuel dans le domaine de la représentation des composants semiconducteurs, les vues en coupe de composants ne sont tracées à l'échelle ni horizontalement ni verticalement. Pour le choix des dimensions, l'homme de l'art se référera à ses connaissances habituelles et à ce qui est enseigné dans la demande de brevet susmentionnée.

On a indiqué précédemment que le composant de la figure 3 pouvait être déclenché par une surtension positive ou négative entre les bornes AB d'une part et la borne G d'autre part ou par un courant excessif circulant dans la résistance de détection Rd disposée entre les bornes A et B.

En fait, il convient d'examiner avec plus d'attention le mode de déclenchement en courant. Ceci peut se voir par exemple en relation avec la figure 1. Quand un courant circule de la borne A vers la borne B, c'est le thyristor Th2 qui est susceptible d'entrer en conduction si la tension entre la borne A (ou B) et la masse est positive. On dira qu'il s'agit du mode ou quadrant de déclenchement [I>0, V>0]. Si le courant circule de la borne B vers la borne A, c'est le thyristor Th1 qui est susceptible d'être conducteur à condition que le potentiel sur les bornes A et B soit inférieur au potentiel sur la borne G. On dira qu'il s'agit du quadrant [I<0, V<0]. En fait, dans le mode de fonctionnement en parole du circuit téléphonique, ce sont les deux seuls quadrants dans lesquels il est possible qu'une surcharge se produise et où il est utile qu'il y ait une protection. On notera que le circuit ne peut normalement pas se déclencher dans le quadrant [I>0, V<0] car alors, c'est le thyristor Th1 qui est polarisé dans le bon sens mais le courant de gâchette n'est pas dans un sens propre au déclenchement de ce thyristor. De même, dans le mode [V>0, I<0], le dispositif ne se déclenche normalement pas puisque c'est le thyristor Th2 qui est polarisé dans le bon sens mais que le courant de gâchette n'est pas dans la direction propre à déclencher ce thyristor.

Toutefois, l'inventeur a constaté en pratique que le circuit était susceptible de se déclencher alors que le système téléphonique était dans le mode sonnerie. Des études plus précises ont montré que ce déclenchement se produisait dans le quadrant [I>0, V<0], c'est-à-dire que le thyristor Th1 entre en conduction alors que normalement son courant de gâchette est dans le mauvais sens. C'est ce déclenchement parasite que la présente invention vise à éviter. Dans le quadrant [I>0, V<0], le signal de sonnerie est négatif. En ce cas, la sonnerie, qui correspond généralement à une tension alternative de l'ordre de 130 volts crête est superposée à une tension continue pouvant aller jusqu'à -72 volts. Il en résulte la présence d'une tension crête maximum d'environ -200 volts. Dans certains circuits téléphoniques, pendant la phase de sonnerie, l'impédance est réduite et on peut atteindre des courants crête de l'ordre de 400 milliampères. Ainsi, dans le schéma de la figure 3, il circule un courant dans la résistance Rd de A vers B alors que l'ensemble des bornes A et B est négatif par rapport à la borne G mais que la tension (-200 volts) est insuffisante pour provoquer un claquage en tension du thyristor Th1 (P2-N-P1-N1). Pendant cette phase, la borne G est positive par rapport à la borne B. Il ne peut donc pas circuler de courant de gâchette dans le thyristor Th1. Toutefois, celui-ci se déclenche.

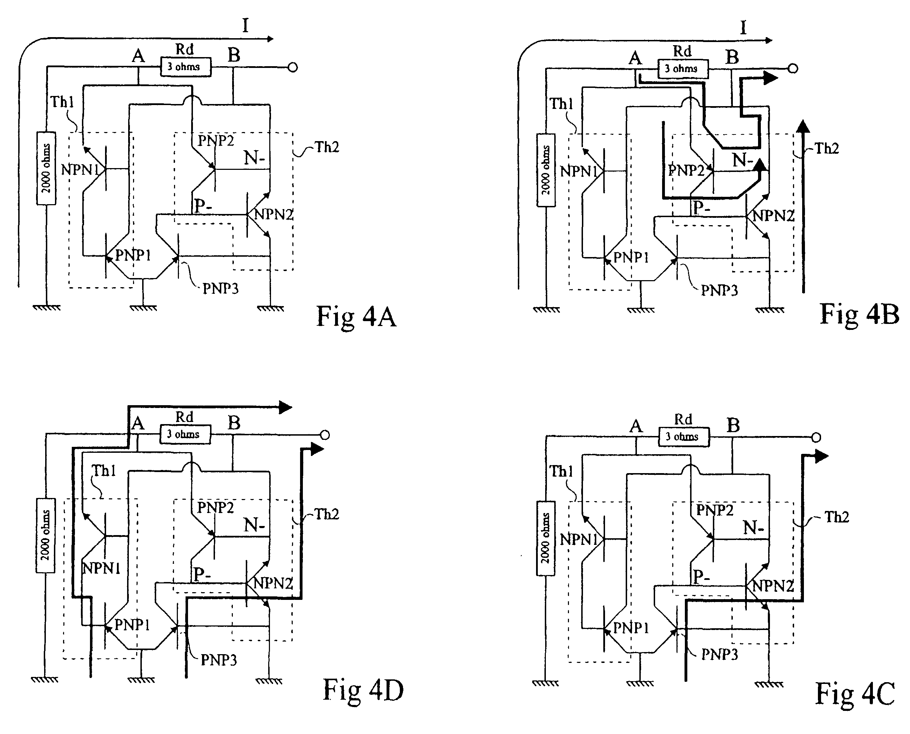

Pour analyser ce déclenchement, la demanderesse a tracé un schéma équivalent du circuit de la figure 3 tel que représenté en figure 4A. Dans ce schéma équivalent, le thyristor Th1 est de façon classique représenté sous forme de l'association de deux transistors NPN1 et PNP1. Le thyristor Th2 est représenté par l'association de deux transistors PNP2 et NPN2. En outre, la demanderesse a fait figurer dans ce schéma un composant parasite dont il s'est avéré qu'il jouait un rôle essentiel dans le phénomène considéré. Ce composant parasite est un transistor de type PNP, PNP3, dont l'émetteur correspond au mur d'isolement 11-12, dont la base correspond au substrat N et dont le collecteur correspond à la région P12 du thyristor Th2. Pour expliquer le phénomène parasite, les figures 4B à 4D illustrent des étapes successives de déclenchement des composants de la figure 4A.

Lors d'une première phase, illustrée en figure 4B, un courant va circuler entre base et émetteur du transistor PNP2 dès que la chute de tension entre les bornes A et B dépasse 0,6 volt. Ceci entraîne la mise en conduction du transistor PNP2 qui provoque la mise en conduction du transistor NPN2 et donc le passage d'un courant de la borne G vers la borne B.

Dans une deuxième phase, illustrée en figure 4C, la mise en conduction du transistor NPN2 entraîne la mise en conduction du transistor parasite PNP3. Ainsi, en se référant à la figure 3, un courant va circuler de la métallisation M2 vers la métallisation M4 en passant par un thyristor parasite comprenant les régions P2, N, P12, N13 et N15.

Dans une dernière phase, du fait de la conduction de ce thyristor parasite, les régions de type P P2, 11 et 12 se mettent à injecter des trous, c'est-à-dire que l'émetteur du transistor PNP1 se met à injecter en même temps que l'émetteur du transistor PNP3 et ceci provoque la mise en conduction du thyristor Th1. C'est là l'effet parasite constaté par la demanderesse.

Pour éviter cet inconvénient, la demanderesse a cherché à modifier le circuit dans lequel est incorporé le composant de la figure 3. Pour cela, la demanderesse a d'abord envisagé de réduire la valeur de la résistance Rd pour éviter le démarrage du processus, c'est-à-dire la mise en conduction du transistor PNP2. Toutefois, cette solution entraîne d'autres inconvénients, à savoir que l'on ne peut plus assurer un déclenchement à seuil suffisamment faible dans les modes de déclenchement normaux en courant des thyristors Th1 et Th2.

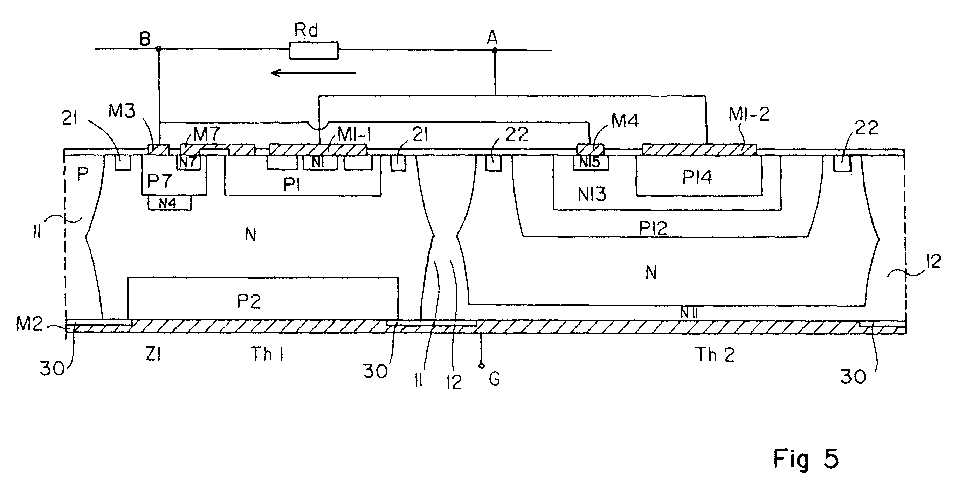

En conséquence, la demanderesse propose la solution représentée en figure 5. Cette figure 5 est pour l'essentiel identique à la figure 3 et ne sera donc pas décrite à nouveau. La différence entre la figure 5 et la figure 3 est que la région P2, au lieu de s'étendre continûment jusqu'à la périphérie du mur d'isolement 11 est disjointe de ce mur d'isolement 11. De plus des couches d'isolement 30 sont formées sur la face arrière avant la métallisation M2 sous le mur d'isolement 11, 12. Le thyristor parasite mentionné précédemment constitué du mur d'isolement 11, du substrat N, de la région P12 et des régions N13-N15 ne peut donc plus devenir passant et entraîner la mise en conduction du thyristor Th1.

De plus pour éviter d'éventuels déclenchements parasites, on prévoit de préférence des anneaux d'arrêt de canal (stop-channel) à la périphérie interne supérieure de chacun des murs 11 et 12 (et au moins du mur 11). Ces anneaux d'arrêt de canal sont respectivement désignés par les références 21 et 22. Ils permettent d'éviter des déclenchements de transistors MOS parasites dus à la présence de tension sur des métallisations courant sur la face supérieure. Par exemple, en figure 5, le trait reliant les métallisations M3 et M4 est en fait une métallisation qui passe au-dessus de l'oxyde de silicium qui est à l'aplomb de la zone comprise entre la région P1 et le mur d'isolement 11. Si cette métallisation est à un potentiel négatif par rapport à la métallisation de face arrière, on risque de faire conduire un transistor MOS à canal P (P11-N-P1) et de faire circuler du courant dans la gâchette du thyristor P2-N-P1-N1 pour l'amorcer à une tension inférieure à celle souhaitée, définie par la diode Zener N4-P7. Les anneaux d'arrêt de canal évitent cet inconvénient.

Bien entendu, la présente invention est susceptible de nombreuses variantes et adjonctions. Notamment, diverses structures usuelles, telles que des zones de court-circuit d'émetteur pourront être réalisées de façon classique par l'homme de l'art. Comme dans le cas de la demande de brevet EP-A-0687051, la structure décrite peut ne constituer qu'une partie d'un composant d'ensemble comprenant par exemple deux structures symétriques analogues à celles de la figure 5. En ce qui concerne les répartitions et les densités de courts-circuits d'émetteur dans les régions N1 et N11, on pourra se référer à l'enseignement de la demande de brevet européen EP-A-0687051.

Par analogie avec la description d'un composant antérieur, on a décrit en détail le cas où le thyristor Th1 est à amplification de gâchette. L'invention s'appliquerait bien entendu également avec avantage dans le cas où il s'agirait d'un thyristor simple. Dans ce cas, la borne B serait directement reliée à la métallisation M7 et les régions N4, P7 et N7 seraient absentes.

## Revendications

1. Composant monolithique de protection contre des surcharges électriques susceptibles de se produire sur un conducteur (AB) en série avec lequel est disposée une résistance de détection (Rd), ce composant étant formé dans un substrat (N) d'un premier type de conductivité ayant une face supérieure et une face inférieure et comprenant :
des premières (M1-1, M1-2) et deuxièmes (M3, M4) métallisations de face supérieure destinées à être connectées aux bornes (A, B) de ladite résistance (Rd) et une troisième métallisation (M2) de face inférieure destinée à être connectée à un potentiel de référence (G) ;
un premier thyristor vertical à gâchette de cathode (Th1) ;
un second thyristor vertical à gâchette d'anode (Th2), du type à déclenchement par courant de gâchette ou par retournement en direct, les premier et second thyristors étant formés tête-bêche entre les premières et troisième métallisations et isolés l'un de l'autre latéralement par un mur d'isolement (11) du deuxième type de conductivité, les deuxièmes métallisations correspondant aux gâchettes de ces thyristors ; et
dans lequel la région d'anode (P2) du premier thyristor, formée du côté de la face inférieure, est disjointe dudit mur d'isolement (11) et dans lequel la face arrière du mur d'isolement est revêtue d'une portion de couche isolante (30).

2. Composant monolithique de protection selon la revendication 1, comprenant une diode à avalanche (Z1) entre les deuxième et troisième métallisations disposée pour que sa mise en avalanche provoque la mise en conduction en direct du premier thyristor, la tension de retournement du second thyristor étant sensiblement égale à la tension d'avalanche de ladite diode à avalanche.

3. Composant monolithique de protection selon la revendication 2, dans lequel l'ensemble du premier thyristor et de la diode à avalanche comprend :
une première couche (P2) du deuxième type de conductivité formée dans la surface inférieure du substrat et disjointe du mur d'isolement (11) ;
des deuxième (P1) et troisième (P7) régions du deuxième type de conductivité formées dans la surface supérieure du substrat ;
des quatrième (N1) et cinquième (N7) régions du premier type de conductivité respectivement formées dans les deuxième et troisième régions ; et
une sixième région (N4) du premier type de conductivité formée à l'interface entre la troisième région (P7) et le substrat (N).

## Patentansprüche

1. Monolithisches Bauteil zum Schutz gegen elektrische Überlastzustände, wie sie an einem Leiter (AB) auftreten können, mit dem in Reihe ein Detektions-Widerstand (Rd) angeordnet ist, wobei dieses Bauteil in einem Substrat (N) eines ersten Leitfähigkeitstyps mit einer Oberseite und einer Unterseite ausgebildet ist und umfasst:
- erste (M1-1, M1-2) und zweite (M3, M4) Oberseitenmetallisierungen zur Anschlussverbindung mit Anschlüssen (A, B) des genannten Widerstands (Rd) und eine dritte Metallisierung (M2) an der Unterseite zur Anschlussverbindung mit einem Bezugspotential (G);
- einen ersten vertikalen Thyristor (Th1) mit Kathodengate;
- einen zweiten vertikalen Thyristor (Th2) mit Anodengate, vom Typ mit Triggerung durch Gatestrom oder durch Kippen in den Durchlasszustand, wobei der erste und der zweite Thyristor in antiparalleler Anordnung zwischen der ersten und der dritten Metallisierung ausgebildet sind und voneinander in seitlicher Richtung durch eine Isolierwandung (11) vom zweiten Leitfähigkeitstyp getrennt sind, wobei die zweiten Metallisierungen den Gates dieser Thyristoren entsprechen; und
- in welchem der von der Rückseite her ausgebildete Anodenbereich (P2) des ersten Transistors von der Isolierwandung (11) getrennt ist und in welchem die Rückseite der Isolierwandung mit einem Bereich aus einer Isolierschicht (30) überzogen ist.

2. Monolithisches Schutzbauteil nach Anspruch 1, welches zwischen der zweiten und der dritten Metallisierung eine Lawinendiode (Z1) in solcher Anordnung aufweist, dass ihr Übergang in den Lawinenzustand den Übergang des ersten Thyristors in den Leitungszustand in Durchlassrichtung bewirkt, und wobei die Kippspannung des zweiten Thyristors im wesentlichen gleich der Lawinendurchbruchspannung der genannten Lawinendiode ist.

3. Monolithisches Schutzbauteil nach Anspruch 2, bei welchem das Aggregat aus dem ersten Thyristor und der Lawinendiode umfasst:
- eine von der Unter- bzw. Rückseite des Substrats her ausgebildete und von der Isolierwandung (11) getrennte erste Schicht (P2) vom zweiten Leitfähigkeitstyp;
- in der Oberseite des Substrats ausgebildete zweite (P1) und dritte (P7) Bereiche vom zweiten Leitfähigkeitstyp;
- in dem zweiten und dem dritten Bereich ausgebildete vierte (N1) und fünfte (N7) Bereiche vom ersten Leitfähigkeitstyp; sowie
- einen an der Grenzfläche zwischen dem dritten Bereich (P7) und dem Substrat (N) ausgebildeten sechsten Bereich (N4) vom ersten Leitfähigkeitstyp.

## Claims

1. A monolithic component of protection against electric overloads likely to occur on a conductor (AB) in series with which is placed a detection resistor (Rd), this component being formed in a substrate (N) of a first conductivity type having an upper surface and a lower surface and including:
first (M1-1, M1-2) and second (M3, M4) upper surface metallizations for connection to the terminals (A, B) of said resistor (Rd) and a third lower surface metallization (M2) for connection to a reference potential (G);
a first vertical cathode-gate thyristor (Th1);
a second vertical anode-gate thyristor (Th2), of the gate current or forward break-over type, the first and second thyristors being formed head-to-tail between the first and third metallizations and being laterally isolated from each other by an isolating wall (11) of the second conductivity type, the second metallizations corresponding to the gates of these thyristors; and
wherein the anode region (P2) of the first thyristor, formed on the lower surface side, is separate from the isolating wall (11) and the rear surface of the isolating wall is coated with a portion of isolating layer (30).

2. The monolithic protection component of claim 1, including an avalanche diode (Z1) between the second and third metallizations placed so that its avalanche causes the forward triggering of the first thyristor, the break-over voltage of the second thyristor being substantially equal to the avalanche voltage of the avalanche diode.

3. The monolithic protection component of claim 2, wherein the assembly of the first thyristor and of the avalanche diode includes:
a first layer (P2) of the second conductivity type formed in the lower surface of the substrate and separate from the isolating wall (11);
second (P1) and third (P7) regions of the second type of conductivity formed in the upper surface of the substrate;
fourth (N1) and fifth (N7) regions of the first type of conductivity respectively formed in the second and third regions; and
a sixth region (N4) of the first type of conductivity formed at the interface between the third region (P7) and the substrate (N).
